# EUROPÄISCHE PATENTSCHRIFT

(11) **EP 2 997 388 B1**
(45) Veröffentlichungstag und Bekanntmachung des Hinweises auf die Patenterteilung: **10.11.2021**
(21) Anmeldenummer: 14722184.0
(22) Anmeldetag: 06.05.2014
(51) Int. Cl.: G01R 31/28, B60R 21/017, H05K 13/08

(54) **VERFAHREN UND VORRICHTUNG ZUM ERKENNEN EINER POLUNG EINER FREILAUFDIODE, AKTUATORSCHALTUNG UND SICHERHEITSVORRICHTUNG FÜR EIN FAHRZEUG**
METHOD AND APPARATUS FOR IDENTIFYING A POLARITY OF A FREEWHEELING DIODE, ACTUATOR CIRCUIT AND SAFETY APPARATUS FOR A VEHICLE
PROCÉDÉ ET DISPOSITIF DE DÉTERMINATION DE LA POLARITÉ D'UNE DIODE DE ROUE LIBRE, CIRCUIT D'ACTIONNEUR ET DISPOSITIF DE SÉCURITÉ POUR VÉHICULE

(30) Priorität: 13.05.2013 DE 102013208690
(43) Veröffentlichungstag der Anmeldung: 23.03.2016
(73) Patentinhaber: Robert Bosch GmbH, 70442 Stuttgart (DE)
(72) Erfinder: KARNER, Ruediger, 70806 Kornwestheim (DE); WALKER, Steffen, 72770 Reutlingen (DE)
(86) Internationale Anmeldenummer: PCT/EP2014/059158
(87) Internationale Veröffentlichungsnummer: WO 2014/184042

(56) Entgegenhaltungen:
- WO-A1-2004/086069
- WO-A1-2013/110523
- DE-A1- 3 443 967
- US-A- 4 779 043

## Beschreibung

### Stand der Technik

Die vorliegende Erfindung bezieht sich auf ein Verfahren und eine Vorrichtung zum Erkennen einer Polung einer parallel zu einem induktiven Aktuator für eine Sicherheitseinrichtung für ein Fahrzeug verschalteten Freilaufdiode, auf eine Aktuatorschaltung und auf eine Sicherheitsvorrichtung für ein Fahrzeug.

Zum Auslösen einer Sicherheitseinrichtung eines Fahrzeugs, beispielsweise eines Airbags, kann ein induktiver Aktuator in Form einer induktiven Last eingesetzt werden. Beim Abschalten von Aktivierungsströmen, z. B. von Airbag-Zündströmen mit induktiven Lasten (z. B. Low-Energy-Actuators, kurz LEA) werden diskrete Freilaufdioden verwendet, um die entstehende Energie oder Spannung der Induktivität nicht in den Endstufen einer Steuereinrichtung, beispielsweise in Form eines ASICs, abbauen zu müssen. Dabei ist zu vermeiden, dass diese Freilaufdioden verpolt eingebaut werden. DE3443967 offenbart eine Vorrichtung zum Prüfen von Bauteilen.

### Offenbarung der Erfindung

Vor diesem Hintergrund werden mit der vorliegenden Erfindung ein Verfahren und eine Vorrichtung zum Erkennen einer Polung einer parallel zu einem induktiven Aktuator für eine Sicherheitseinrichtung für ein Fahrzeug verschalteten Freilaufdiode, eine Aktuatorschaltung und eine Sicherheitsvorrichtung für ein Fahrzeug gemäß den Hauptansprüchen vorgestellt. Vorteilhafte Ausgestaltungen ergeben sich aus den jeweiligen Unteransprüchen und der nachfolgenden Beschreibung.

Eine Polung einer parallel zu einem induktiven Aktuator geschalteten Freilaufdiode kann überprüft werden, indem an die Freilaufdiode ein Prüfstrom angelegt wird und eine daraus resultierende elektrische Spannung an der Freilaufdiode ausgewertet wird. Vorteilhafterweise kann die Auswertung der elektrischen Spannung durch einen einfachen Schwellwertvergleich erfolgen. Zudem kann die Polung während einer Inbetriebnahme oder eines Betriebs des induktiven Aktuators, d. h. im verbauten Zustand des induktiven Aktuators erfolgen.

Ein Verfahren zum Erkennen einer Polung einer parallel zu einem induktiven Aktuator für eine Sicherheitseinrichtung für ein Fahrzeug verschalteten Freilaufdiode umfasst die folgenden Schritte:
Anlegen eines Prüfstroms an einen Anschluss der Freilaufdiode; und
Durchführen eines Vergleichs zwischen einer an dem Anschluss anliegenden Spannung und einer Schwellspannung, während des Anlegens des Prüfstroms, wobei ein Ergebnis des Vergleichs die Polung der Freilaufdiode anzeigt.

Unter einem Fahrzeug kann beispielsweise ein Personenkraftwagen, ein Lastkraftwagen oder ein Motorrad verstanden werden.

Unter einer Sicherheitseinrichtung kann eine Einrichtung des Fahrzeugs verstanden werden, die ausgebildet ist, um die Insassen, das Fahrzeug oder weitere Verkehrsteilnehmer vor Schaden zu bewahren. Darunter fällt beispielsweise ein Überrollbügel, eine aktive Motorhaube, ein aktiver Fahrzeugsitz, eine Einrichtung zum Straffen eines Sicherheitsgurts oder ein Airbag.

Unter einem induktiven Aktuator kann eine Einrichtung verstanden werden, die ausgebildet ist, um die Sicherheitseinrichtung ansprechend auf einen durch den induktiven Aktuator fließenden Aktivierungsstrom zu aktivieren, auszulösen, zu bewegen oder einzustellen. Der Aktuator kann ausgebildet sein, um ansprechend auf den Aktivierungsstrom ein Magnetfeld zum aktiveren der Sicherheitseinrichtung zu erzeugen. Es kann sich somit um einen magnetischen Aktuator handeln. Ein solches Magnetfeld übt dann eine Kraft auf ein magnetisierbares Material aus, das sich hierauf in dem Magnetfeld bewegt. Die Bewegung wiederum kann zum Entsichern einer Haltevorrichtung führen, wodurch eine Sicherheitseinrichtung ausgelöst werden kann. Beispielsweise dadurch, dass die Sicherheitseinrichtung selbst unter mechanischer Spannung steht und die Energie, die in der Spannung gespeichert ist, durch das Entsichern der Haltevorrichtung freigesetzt wird. Beispielsweise kann der Aktuator eine Induktivität oder Spule aufweisen oder als eine Induktivität oder Spule ausgeführt sein.

Unter einer Freilaufdiode kann vorliegend eine Diode verstanden werden, die so angebracht ist, dass im Falle einer korrekten Polung der Freilaufdiode eine von dem induktiven Aktuator induzierte Spannung über die Freilaufdiode abgebaut werden kann. Im Falle einer fehlerhaften Polung der Freilaufdiode kann ein Aktivierungsstrom zum Auslösen des induktiven Aktuators anstelle durch den Aktuator zu fließen, durch die Freilaufdiode fließen und so eine Auslösung des Aktuators verhindern. Daher ist es wichtig, die Polung der Freilaufdiode im verschalteten oder eingebauten Zustand prüfen oder erkennen zu können.

Der Prüfstrom kann unter Verwendung einer geeigneten Stromquelle oder Spannungsquelle an den Anschluss der Freilaufdiode angelegt werden. Bilden die Freilaufdiode und der induktive Aktuator eine Aktuatoreinheit, so kann der Prüfstrom auch an einen Anschluss der Aktuatoreinheit, der mit dem Anschluss der Freilaufdiode und einem Anschluss des induktiven Aktuators verbunden ist, angelegt werden.

Zum Durchführen des Vergleichs kann die an dem Anschluss der Freilaufdiode anliegende Spannung erfasst und mit der Schwellspannung, die einen vordefinierten Wert aufweisen kann, verglichen werden. Die Schwellspannung kann größer als eine Diodenflussspannung der Freilaufdiode sein. Zum Durchführen des Vergleichs kann eine geeignete Vergleichseinrichtung, beispielsweise ein Komparator verwendet werden. Abhängig von dem Ergebnis des Vergleichs kann ein Vergleichssignal ausgegeben werden, das das Ergebnis repräsentiert und die die Polung der Freilaufdiode anzeigt. Alternativ kann ein dem Vergleichssignal entsprechender Vergleichswert ausgelesen werden. Gemäß einem Ausführungsbeispiel wird im Schritt des Anlegens der Prüfstrom mit einer Stromstärke angelegt, die geringer als eine Stromstärke eines Aktivierungsstroms zum Auslösen des induktiven Aktuators ist. Auf diese Weise kann die Polung der Freilaufdiode erkannt werden, jedoch eine Fehlauslösung des induktiven Aktuators vermieden werden.

Der Schritt des Anlegens des Prüfstroms kann während einer Initialisierungsphase einer Steuereinrichtung zum Steuern des induktiven Aktuators durchgeführt werden. Alternativ oder zusätzlich kann der Schritt des Anlegens des Prüfstroms während eines Normalbetriebsmodus der Steuereinrichtung zum Steuern des induktiven Aktuators durchgeführt werden. Auf diese Weise kann eine korrekte Polung oder eine fehlerhafte Polung, also eine Verpolung durch eine geeignete im Fahrzeug verbaute Schaltung erkannt werden.

Unter einer Steuereinrichtung kann eine Einrichtung verstanden werden, die dazu geeignet ist, eine Aktivierung der Sicherheitseinrichtung unter Verwendung des induktiven Aktuators zu steuern. Beispielsweise kann die Steuereinrichtung als eine integrierte Schaltung ausgeführt sein. Die Steuereinrichtung kann Einrichtungen umfassen, die ausgebildet sind, um die Schritte des Verfahrens zum Erkennen der Polung der Freilaufdiode auszuführen oder anzusteuern.

Im Schritt des Anlegens kann der Prüfstrom an den Anschluss angelegt werden, der der Kathode der Freilaufdiode für den Fall entspricht, in dem die Freilaufdiode in Bezug zu dem induktiven Aktuator oder im Bezug zu einer Ansteuereinrichtung des induktiven Aktuators korrekt gepolt verschaltet ist. Eine solche Ansteuereinrichtung kann beispielsweise Schalter zum gesteuerten Verbinden des induktiven Aktuators und somit der Freilaufdiode mit Betriebsspannungspotenzialen aufweisen. Beispielsweise können zum Aktiven des Aktuators ein erster Anschluss des induktiven Aktuators mit einer Aktivierungsspannung und ein zweiter Anschluss des induktiven Aktuators mit Masse verbunden werden. Ist die Freilaufdiode korrekt eingebaut und somit korrekt gepolt, so kann die Kathode der Freilaufdiode mit dem ersten Anschluss des induktiven Aktuators elektrisch leitfähig verbunden sein. Somit ist die Freilaufdiode bei korrekter Polung in Sperrrichtung in Bezug auf den Aktivierungsstrom zum Aktivieren des induktiven Aktuators geschaltet.

Gemäß einer Ausführungsform kann im Schritt des Durchführens das Ergebnis des Vergleichs anzeigen, dass die Freilaufdiode korrekt gepolt verschaltet ist, wenn die an dem Anschluss anliegende Spannung größer als die Schwellspannung ist. Zusätzlich oder alternativ kann im Schritt des Durchführens das Ergebnis des Vergleichs anzeigen, dass die Freilaufdiode verpolt verschaltet ist, wenn die an dem Anschluss anliegende Spannung kleiner als die Schwellspannung ist. Auf diese Weise kann auf einfache Weise durch Betrachten des Ergebnisses erkannt werden, ob die Freilaufdiode korrekt gepolt oder verpolt verbaut ist.

Im Schritt des Durchführens kann zumindest ein weiterer Vergleich zwischen der an dem Anschluss anliegenden Spannung und der Schwellspannung, während des Anlegens des Prüfstroms, durchgeführt werden. Eine Kombination der Ergebnisse aus den Vergleichen kann die Polung der Freilaufdiode anzeigen. Beispielsweise können zwei, drei oder mehr Vergleiche durchgeführt und deren Ergebnisse ausgewertet werden, um die Polung zu erkennen. Dadurch kann vermieden werden, dass die Polung aufgrund eines falschen Ergebnisses verkehrt angezeigt wird. Zum Erhalten mehrere Ergebnisse können mehrere Vergleiche zeitlich aufeinanderfolgend durchgeführt werden, es kann ein aus einem kontinuierlichen Vergleichsvorgang resultierendes Vergleichssignal zu unterschiedlichen Zeitpunkten abgetastet werden oder es können aus einem kontinuierlichen Vergleichsvorgang hervorgehende Vergleichswerte zu unterschiedlichen Zeiten ausgelesen werden. Auch können die Schritte des Anlegens und des Durchführens mehrmals wiederholt ausgeführt werden, um mehrere Ergebnisse zu erhalten. Beispielsweise können solange Ergebnisse generiert werden, bis eine vorgegebene Anzahl an aufeinanderfolgenden gleichen Ergebnissen erzielt wird.

Das Verfahren kann einen Schritt des Empfangens eines Diagnosesignals über eine Schnittstelle zu einem Datenbus umfassen. Dabei kann der Schritt des Anlegens des Prüfstroms ansprechend auf das Empfangen des Diagnosesignals ausgeführt werden. Bei dem Datenbus kann es sich beispielsweise um einen seriellen Datenbus handeln, wie er in Fahrzeugen verwendet wird. Das Diagnosesignal kann beispielsweise von einer Steuereinrichtung zum Steuern des induktiven Aktuators ausgegeben werden.

Eine Vorrichtung zum Prüfen einer Polung einer parallel zu einem induktiven Aktuator für eine Sicherheitseinrichtung für ein Fahrzeug geschalteten Freilaufdiode weist die folgenden Merkmale auf:
eine Einrichtung zum Anlegen eines Prüfstroms an einen Anschluss der Freilaufdiode; und
eine Einrichtung zum Durchführen eines Vergleichs zwischen einer an dem Anschluss anliegenden Spannung und einer Schwellspannung, während des Anlegens des Prüfstroms, wobei ein Ergebnis des Vergleichs die Polung der Freilaufdiode anzeigt.

Die Vorrichtung zum Prüfen der Polung der Freilaufdiode ist ausgebildet, um die Schritte des genannten Verfahrens zum Prüfen der Polung der Freilaufdiode in entsprechenden Einrichtungen durchzuführen bzw. umzusetzen. Auch durch diese Ausführungsvariante der Erfindung in Form einer Vorrichtung kann die der Erfindung zugrunde liegende Aufgabe schnell und effizient gelöst werden.

Unter einer Vorrichtung kann vorliegend ein elektrisches Gerät verstanden werden, das Signale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Eine Aktuatorschaltung weist folgende Merkmale auf:
einen induktiven Aktuator zum Aktivieren einer Sicherheitseinrichtung;
eine Freilaufdiode mit einem ersten Anschluss und einem zweiten Anschluss, wobei die Freilaufdiode über den ersten und den zweiten Anschluss parallel zu dem induktiven Aktuator verschaltetet ist; und
eine genannten Vorrichtung zum Prüfen einer Polung der Freilaufdiode, wobei die Einrichtung zum Anlegen des Prüfstroms ausgebildet ist, um den Prüfstrom an den ersten Anschluss der Freilaufdiode anzulegen und die Einrichtung zum Durchführen des Vergleichs ausgebildet ist, um den Vergleich zwischen der an dem ersten Anschluss anliegenden Spannung und der Schwellspannung durchzuführen.

Eine Sicherheitsvorrichtung für ein Fahrzeug weist die folgenden Merkmale auf:
eine Sicherheitseinrichtung zum Schützen eines Insassen des Fahrzeugs bei einer Kollision des Fahrzeugs; und
eine genannte Aktuatorschaltung, wobei der induktive Aktuator der Aktuatorschaltung mit der Sicherheitseinrichtung gekoppelt ist; und
eine Steuereinrichtung zum Bereitstellen eines Aktivierungsstroms an den induktiven Aktuator, um den induktiven Aktuator und damit die mit dem induktiven Aktuator gekoppelte Sicherheitseinrichtung bei einer Kollision des Fahrzeugs aktivieren zu können.

Durch den induktiven Aktuator kann die Sicherheitseinrichtung beispielsweise vor, während oder nach einer erfolgten Kollision aktiviert werden.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn der Programmcode auf einem Computer oder einer Vorrichtung ausgeführt wird. Somit können die in dem Programmcode definierten Schritte des Verfahrens von Einrichtungen des Computers oder der Vorrichtung umgesetzt werden.

Die Erfindung wird nachstehend anhand der beigefügten Zeichnungen beispielhaft näher erläutert. Es zeigen:
- Fig. 1: eine schematische Darstellung einer Sicherheitsvorrichtung für ein Fahrzeug gemäß einem Ausführungsbeispiel der vorliegenden Erfindung;
- Fig. 2: ein Ablaufdiagramm eines Verfahrens zum Erkennen einer Polung einer Freilaufdiode gemäß einem Ausführungsbeispiel der vorliegenden Erfindung;
- Fig. 3: eine Darstellung von Signalverläufen bei einer korrekt eingebauten Freilaufdiode, gemäß einem Ausführungsbeispiel der vorliegenden Erfindung; und
- Fig. 4: eine Darstellung von Signalverläufen bei einer verpolt eingebauten Freilaufdiode, gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

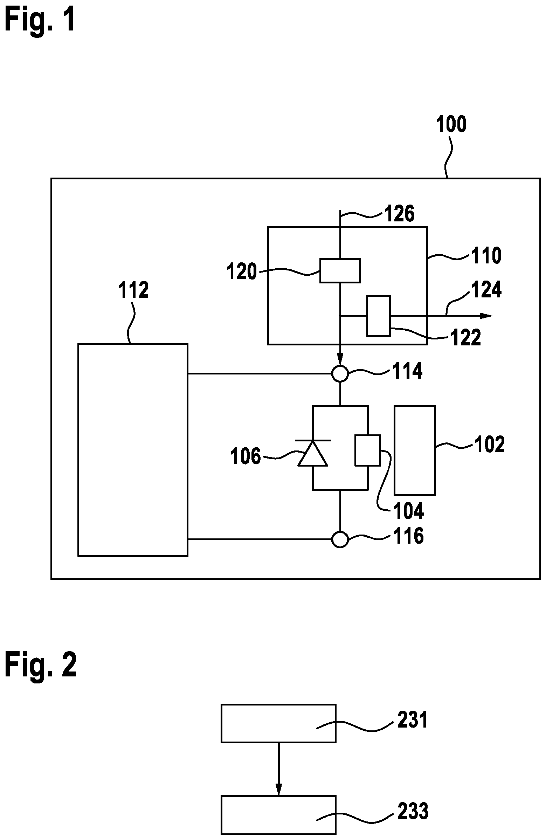

Fig. 1 zeigt eine schematische Darstellung einer Sicherheitsvorrichtung für ein Fahrzeug 100 gemäß einem Ausführungsbeispiel der vorliegenden Erfindung. Die Sicherheitsvorrichtung umfasst eine Sicherheitseinrichtung 102, beispielsweise zum Schützen einer Person bei einer Kollision des Fahrzeugs 100. Beispielsweise kann die Sicherheitseinrichtung 102 einen Airbag umfassen. Ferner umfasst die Sicherheitsvorrichtung eine Aktuatorschaltung mit einem induktiven Aktuator 104 zum Aktivieren der Sicherheitseinrichtung 102, einer parallel zu dem induktiven Aktuator 104 geschalteten Freilaufdiode 106 und einer Vorrichtung 110 zum Prüfen einer Polung der Freilaufdiode 106.

Gemäß diesem Ausführungsbeispiel weist die Sicherheitsvorrichtung ferner eine Steuereinrichtung 112 auf, die ausgebildet ist, um einen Aktivierungsstrom zum Aktivieren der Sicherheitseinrichtung 102 unter Verwendung des induktiven Aktuators 104 an den induktiven Aktuator 104 bereitzustellen. Beispielsweise kann die Steuereinrichtung 112 ausgebildet sein, um zum Bereitstellen des Aktivierungsstroms einen ersten Anschluss des induktiven Aktuators 104 und somit einen ersten Anschluss 114 der Freilaufdiode 106 über einen Schalter, beispielsweise einen sogenannten High-Side-Schalter mit einer Spannungsquelle und einen zweiten Anschluss des induktiven Aktuators 104 und somit einen zweiten Anschluss 116 der Freilaufdiode 106 über einen weiteren Schalter, beispielsweise einen sogenannten Low-Side-Schalter mit einem Masseanschluss der Sicherheitsvorrichtung zu verbinden. Ist die Freilaufdiode 106 korrekt gepolt verschaltet, so kann der Aktivierungsstrom durch den induktiven Aktuator 104 fließen. Die Freilaufdiode 106 ist für den Aktivierungsstrom in Sperrrichtung geschaltet.

Die Vorrichtung 110 zum Prüfen kann in die Steuereinrichtung 112 integriert oder als separate Schaltung ausgeführt sein. Die Vorrichtung 110 zum Prüfen ist ausgebildet, um zu erkennen, ob die Freilaufdiode 106 korrekt gepolt verschaltet oder verpolt ist. Dazu weist die Vorrichtung 110 zum Prüfen eine Einrichtung 120 auf, die ausgebildet ist, um einen Prüfstrom an den ersten Anschluss 114 der Freilaufdiode 106 anzulegen. Ferner weist die Vorrichtung 110 zum Prüfen eine Einrichtung 122 auf, die ausgebildet ist, um einen Vergleich zwischen einer an dem ersten Anschluss 114 anliegenden Spannung und einer Schwellspannung durchzuführen, während der Prüfstrom an den ersten Anschluss 114 angelegt wird. Gemäß diesem Ausführungsbeispiel ist die Einrichtung 122 ausgebildet, um ein Ergebnis des Vergleichs in Form eines Vergleichssignals 124 auszugeben. Das Vergleichssignal 124 ist ausgebildet, um anzuzeigen, ob die Freilaufdiode 106 in Bezug auf Ihre Polung korrekt oder fehlerhaft verschaltet ist, d. h., ob die Freilaufdiode 106 in Bezug auf den Aktivierungsstrom in Sperrrichtung oder in Durchlassrichtung verschaltet ist. Eine Flussrichtung des Aktivierungsstroms kann dabei einer Flussrichtung des Prüfstroms entsprechen.

Die Einrichtung 120 kann beispielsweise ausgebildet sein, um den Prüfstrom für eine Zeitdauer von weniger als 1000ps, beispielsweise für eine Zeitdauer zwischen 300ps und 700ps bereitzustellen. Der Prüfstrom kann einen Wert von weniger als 100mA, beispielsweise einen Wert zwischen 40mA und 80mA aufweisen.

Gemäß einem Ausführungsbeispiel weist die Vorrichtung 110 eine Schnittstelle zu einem Datenbus 126 auf. Die Vorrichtung 110 ist ausgebildet, um über den Datenbus ein Diagnosesignal zu empfangen und ansprechend auf einen Empfang des Diagnosesignals den Prüfstrom in den ersten Anschluss 114 einzuspeisen.

Gemäß einem Ausführungsbeispiel kann der beschriebene Ansatz zur Diagnose von Freilaufdioden 106 in Zündkreisen mit einem Aktuator 104 in Form einer induktiver Last eingesetzt werden.

Der Ansatz basierte auf einer Diagnose, welche verpolte Freilaufdioden 106 erkennt. Diese Diagnose wird gemäß einem Ausführungsbeispiel über ein serielles Bussystem 126, beispielsweise einem SPI (serial pheripheral interface) getriggert und dann von einer Steuereinrichtung 112, beispielsweise in Form eines ASIC aus abgesteuert. In diesem Fall kann das Diagnosesignal über das Bussystem 126, anders als in Fig. 1 gezeigt, direkt von der Steuereinrichtung 112 empfangen werden. Wird der Test, also die Diagnose der Freilaufdiode 106, z. B. in der Initialisierungsphase eines Steuergeräts des Fahrzeugs 100 durchgeführt, können aufwendige Tests bezüglich Diodenverpolung im Werk entfallen. Dadurch ergibt sich eine erhebliche Einsparung von Testkosten. Zudem ergibt sich eine Erhöhung der Sicherheit, da der Test bei jeder Initialisierungsphase und auch im Normalbetrieb des Steuergeräts durchgeführt werden kann. Zudem wird ein Schutz der ASIC-Endstufen, beispielsweise der Steuereinrichtung 112, vor Zerstörung, bei Abschaltung des Zündstroms mit verpolter Freilaufdiode 106, gewährleistet. Beispielsweise ist bei einer Sicherheitseinrichtung 102 in Form eines Airbags die Diagnose integrierbar in eine bereits vorhandene Zündkreiswiderstandsmessung und ist somit flächenneutral und zeitneutral.

Fig. 2 zeigt ein Ablaufdiagramm eines Verfahrens zum Erkennen einer Polung einer Freilaufdiode gemäß einem Ausführungsbeispiel der vorliegenden Erfindung. Bei der Freilaufdiode kann es sich um die in Fig. 1 gezeigte Freilaufdiode handeln, die in einer Parallelschaltung mit einem Aktuator, beispielsweise in Form einer Induktivität, verschaltet ist.

In einem Schritt 231 wird zum Erkennen der Polung der Freilaufdiode ein Prüfstrom an einen Anschluss der Freilaufdiode angelegt. Der Prüfstrom kann für einen bestimmten Zeitraum oder bis das Erkennen der Polung abgeschlossen ist, angelegt werden.

In einem Schritt 233 wird eine Spannung, die an dem Anschluss der Freilaufdiode an dem der Prüfstrom anliegt, mit einer Schwellspannung verglichen. Ein Ergebnis des Vergleichs kann ausgegeben werden und die Polung der Freilaufdiode anzeigen. Der Vergleich der Spannung mit der Schwellspannung kann mehrmals wiederholt durchgeführt werden. Auch kann ein solcher Vergleich über einen Zeitraum durchgeführt werden und ein Vergleichsergebnis kann zu mehreren unterschiedlichen Zeitpunkten innerhalb des Zeitraums ausgelesen werden, um mehrere Vergleichsergebnisse zu erhalten. Mehrere Vergleichsergebnisse können kombiniert oder miteinander verknüpft werden, um die Polung der Freilaufdiode noch sicherer erkennen zu können.

Gemäß einem Ausführungsbeispiel werden die Schritte 231, 233 mehrmals wiederholt ausgeführt, um basierend auf mehreren Vergleichsergebnissen sicher entscheiden zu können, ob die Freilaufdiode korrekt oder verkehrt gepolt verbaut ist.

Die Schritte 231, 233 des Verfahrens können beispielsweise von einer Vorrichtung zum Prüfen umgesetzt werden, wie sie in Fig. 1 gezeigt ist.

Wenn während der Prüfung der Polung der Freilaufdiode eine Aktivierung der Sicherheitseinrichtung erforderlich ist, so kann der Prüfstrom durch einen Aktivierungsstrom des induktiven Aktuators überlagert werden.

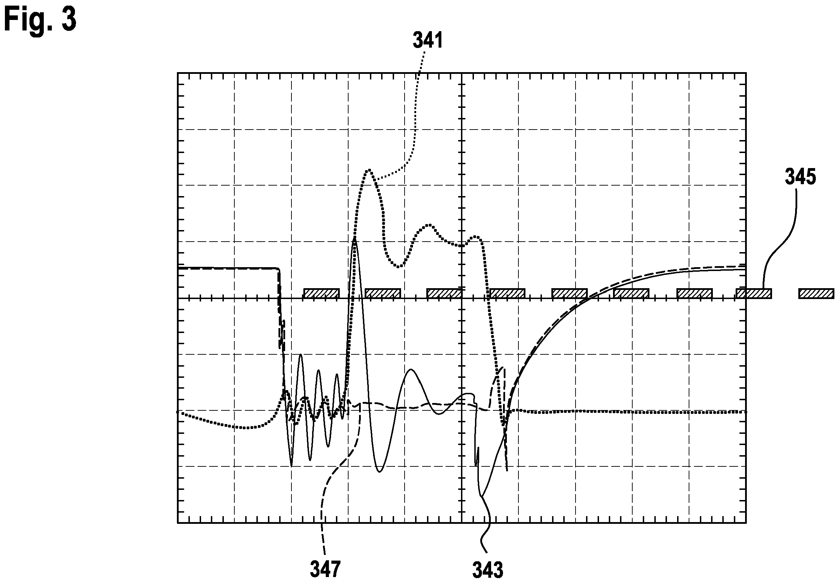

Fig. 3 zeigt eine Darstellung von Signalverläufen in einer Aktuatorschaltung bei einer korrekt eingebauten Freilaufdiode gemäß einem Ausführungsbeispiel der vorliegenden Erfindung. Dabei kann es sich um eine Freilaufdiode handeln, wie sie in Fig. 1 gezeigt ist. Zum Prüfen der Polung der Freilaufdiode wird ein Prüfstrom 341 in den in Fig. 1 gezeigten ersten Anschluss der Freilaufdiode eingespeist. Der Prüfstrom 341 fließt, wenn die Freilaufdiode korrekt eingebaut ist, d. h. sperrend für den Prüfstrom 341 ist, durch den induktiven Aktuator. Dadurch baut sich an dem ersten Anschluss eine Prüfspannung 343 auf, die zum Überprüfen der Polung der Freilaufdiode mit einer Schwellspannung 345 verglichen wird. Ferner ist in Fig. 3 ein Verlauf einer Spannung 347 an dem zweiten Anschluss der Freilaufdiode gezeigt.

Der Verlauf des Prüfstroms 341 weist eine Art Rechteckimpuls auf. Mit steigender Flanke des Prüfstroms 341 steigt auch die Prüfspannung 343 an und übersteigt dabei die Schwellspannung 345, die höher als die Diodenflussspannung ist. Dieses Überschreiten wird so gedeutet, dass die Freilaufdiode korrekt eingebaut ist. Bei einer verpolten Diode würde die Prüfspannung 343 vor Erreichen der Schwellspannung 345 durch einen Stromfluss durch die Freilaufdiode abgebaut werden. Die Prüfspannung 343 fällt wieder ab, hier auch unter die Schwellspannung 345, bevor der Prüfstrom 341 seinen maximalen Wert erreicht hat.

Die Spannung 347 weist während des Anstiegs des Prüfstroms 341 keinen Anstieg auf.

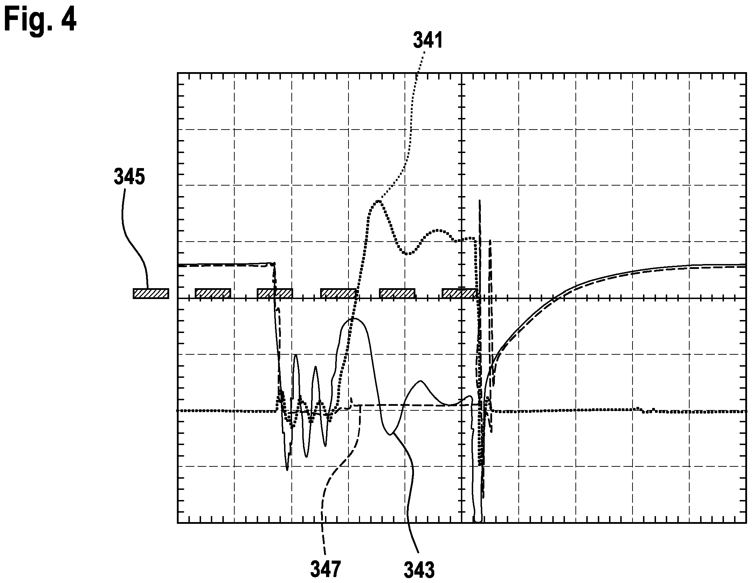

Fig. 4 zeigt eine Darstellung von Signalverläufen bei einer, im Unterschied zu Fig. 3, verpolt eingebauten Freilaufdiode gemäß einem Ausführungsbeispiel der vorliegenden Erfindung.

Der Verlauf des Prüfstroms 341 weist wieder eine Art Rechteckimpuls auf. Mit steigender Flanke des Prüfstroms 341 steigt auch die Prüfspannung 343 an, fällt jedoch vor Erreichen der Schwellspannung 345 wieder ab und überschreitet die Schwellspannung 345 somit nicht. Dieses Nicht-Überschreiten während der gesamten Zeitdauer während der der Prüfstrom 341 eingespeist wird, wird so gedeutet, dass die Freilaufdiode verpolt eingebaut ist. Die Spannung 347 weist während des Anstiegs des Prüfstroms 341 keinen Anstieg, beim Abfall des Prüfstroms 341 jedoch einen kurzzeitigen sprunghaften Anstieg, hier über die Schwellspannung 345 hinaus, auf.

In den Figuren 3 und 4 sind wichtige Spannungsverläufe 343, 347 einer Zündkreiswiderstandsmessung in einem Niedrigenergiezündkreis, einem sogenannten LEA-Zündkreis, dargestellt. Ein Verlauf stellt den Prüfstrom 341 durch den Zündkreis dar. Der Prüfstrom 341 beträgt beispielsweise 60mA für 500ps. Ein weiterer Verlauf stellt die Spannung 343 an der Zündkreis Plus-Seite, also dem in Fig. 1 gezeigten ersten Anschluss und ein weiterer Verlauf stellt die Spannung 347 an der Zündkreis Minus-Seite, also dem in Fig. 1 gezeigten zweiten Anschluss dar.

In Fig. 3 ist die Freilaufdiode korrekt eingebaut, in Fig. 4 ist die Freilaufdiode dagegen verpolt eingebaut.

In Fig. 3 ist erkennbar, wie die Spannung 343 an der Plus-Seite in Abhängigkeit vom Stromanstieg des Prüfstroms 341 ansteigt (U_L=L*dl/dt). Während des Prüfstromanstiegs fließt kein Strom durch die korrekt eingebaute Freilaufdiode.

Im Gegensatz dazu unterscheidet das Verhalten aus Fig. 4. Hier ist die Freilaufdiode verpolt. Bei Anstieg des Prüfstroms 341 wird die Diode bestromt, die Spannung 345 an der Plus-Seite überschreitet eine Diodenflussspannung nicht.

Ziel der Diagnose ist es, diese beiden Fälle voneinander zu unterscheiden. Dies wird durch Einführung einer Spannungsschwelle 345 erreicht. Dazu wird eine Komparatorschaltung abgefragt während der Prüfstrom 341 angesteuert wird. Erkennt diese Komparatorschaltung, dass die Schwelle 345 eine bestimmte Mindestanzahl, z. B. mindestens drei Mal überschritten wird, so ist das Ergebnis positiv, d. h. die Freilaufdiode ist korrekt eingebaut. Die Komparatorschaltung kann beispielsweise Teil der in Fig. 1 gezeigten Einrichtung zum Durchführen des Vergleichs sein.

Vorteilhafterweise kann die Diagnose mit einer standardmäßigen Zündkreiswiderstandsmessung auskommen. Mit anderen Worten kann abhängig von einem zwischen dem in Fig. 1 gezeigten ersten und zweiten Anschluss anliegender Widerstand ausgewertet werden, um zu erkennen, ob die Freilaufdiode korrekt oder verpolt verbaut ist. Die Widerstandsmessung kann durchgeführt werden, während der Prüfstrom anliegt.

Die beschriebenen und in den Figuren gezeigten Ausführungsbeispiele beziehen sich alle ausschließlich auf die Erfindung, die durch die Ansprüche definiert ist, und sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden. Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren zum Erkennen einer Polung einer parallel zu einem induktiven Aktuator (104) für eine Sicherheitseinrichtung (102) für ein Fahrzeug (100) verschalteten Freilaufdiode (106), wobei das Verfahren die folgenden Schritte umfasst:
Anlegen (231) eines Prüfstroms (341) an einen Anschluss (114) der Freilaufdiode (106); und
Durchführen (233) eines Vergleichs zwischen einer an dem Anschluss (114) anliegenden Spannung (343) und einer Schwellspannung (345), während des Anlegens (231) des Prüfstroms (341), wobei ein Ergebnis (124) des Vergleichs die Polung der Freilaufdiode (106) anzeigt,
**gekennzeichnet durch**
einem Schritt des Empfangens eines Diagnosesignals über eine Schnittstelle zu einem Datenbus (126), wobei der Schritt des Anlegens (231) des Prüfstroms (341) ansprechend auf das Empfangen des Diagnosesignals ausgeführt wird.

2. Verfahren gemäß Anspruch 1, bei dem im Schritt des Anlegens (231) der Prüfstrom (341) mit einer Stromstärke angelegt wird, die geringer als eine Stromstärke eines Aktivierungsstroms zum Auslösen des induktiven Aktuators (104) ist.

3. Verfahren gemäß einem der vorangegangenen Ansprüche, bei dem der Schritt des Anlegens (231) des Prüfstroms (341) während einer Initialisierungsphase oder während eines Normalbetriebsmodus einer Steuereinrichtung (112) zum Steuern des induktiven Aktuators (104) durchgeführt wird.

4. Verfahren gemäß einem der vorangegangenen Ansprüche, bei dem im Schritt des Anlegens (231) der Prüfstrom (341) an den Anschluss (114) angelegt wird, der der Kathode der Freilaufdiode (106) für den Fall entspricht, in dem die Freilaufdiode (106) in Bezug zu dem Aktuator (104) korrekt gepolt verschaltet ist.

5. Verfahren gemäß einem der vorangegangenen Ansprüche, bei dem im Schritt des Durchführens (233) das Ergebnis (124) des Vergleichs anzeigt, dass die Freilaufdiode (106) korrekt gepolt verschaltet ist, wenn die an dem Anschluss (114) anliegende Spannung (343) größer als die Schwellspannung (345) ist und/oder bei dem im Schritt des Durchführens (233) das Ergebnis (124) des Vergleichs anzeigt, dass die Freilaufdiode (106) verpolt verschaltet ist, wenn die an dem Anschluss (114) anliegende Spannung (343) kleiner als die Schwellspannung (345) ist.

6. Verfahren gemäß einem der vorangegangenen Ansprüche, bei dem im Schritt des Durchführens (233) zumindest ein weiterer Vergleich zwischen der an dem Anschluss (114) anliegenden Spannung (343) und der Schwellspannung (345), während des Anlegens (231) des Prüfstroms (341), durchgeführt wird, und eine Kombination der Ergebnisse (124) aus den Vergleichen die Polung der Freilaufdiode (106) anzeigt.

7. Vorrichtung (110) zum Prüfen einer Polung einer parallel zu einem induktiven Aktuator (104) für eine Sicherheitseinrichtung (102) für ein Fahrzeug (100) geschalteten Freilaufdiode (106), wobei die Vorrichtung (110) die folgenden Merkmale aufweist:
eine Einrichtung (120) zum Anlegen eines Prüfstroms (341) an einen Anschluss (114) der Freilaufdiode (106); und
eine Einrichtung (122) zum Durchführen eines Vergleichs zwischen einer an dem Anschluss (114) anliegenden Spannung (343) und einer Schwellspannung (345), während des Anlegens (231) des Prüfstroms (341),
wobei ein Ergebnis (124) des Vergleichs die Polung der Freilaufdiode (106) anzeigt, wobei die Vorrichtung (110) dazu ausgestaltet ist, ein Diagnosesignal über eine Schnittstelle zu einem Datenbus (126) zu empfangen, wobei das Anlegen (231) des Prüfstroms (341) ansprechend auf das Empfangen des Diagnosesignals ausgeführt wird.

8. Aktuatorschaltung mit folgenden Merkmalen:
einem induktiven Aktuator (104) zum Aktivieren einer Sicherheitseinrichtung (102);
einer Freilaufdiode (106) mit einem ersten Anschluss (114) und einem zweiten Anschluss (116), wobei die Freilaufdiode (106) über den ersten und den zweiten Anschluss (114, 116) parallel zu dem induktiven Aktuator (104) verschaltetet ist; und
einer Vorrichtung (110) gemäß Anspruch 7 zum Prüfen einer Polung der Freilaufdiode (106), wobei die Einrichtung (120) zum Anlegen des Prüfstroms (341) ausgebildet ist, um den Prüfstrom (341) an den ersten Anschluss (114) der Freilaufdiode (106) anzulegen und die Einrichtung (122) zum Durchführen des Vergleichs ausgebildet ist, um den Vergleich zwischen der an dem ersten Anschluss (114) anliegenden Spannung (343) und der Schwellspannung (345) durchzuführen.

9. Sicherheitsvorrichtung für ein Fahrzeug (100), wobei die Sicherheitsvorrichtung die folgenden Merkmale aufweist:
eine Sicherheitseinrichtung (102) zum Schützen einer Person bei einer Kollision des Fahrzeugs (100); und
einer Aktuatorschaltung gemäß Anspruch 8, wobei der induktive Aktuator (104) der Aktuatorschaltung mit der Sicherheitseinrichtung (102) gekoppelt ist; und
einer Steuereinrichtung (112) zum Bereitstellen eines Aktivierungsstroms an den induktiven Aktuator (104), um den induktiven Aktuator (104) und damit die mit dem induktiven Aktuator (104) gekoppelte Sicherheitseinrichtung (102) bei einer Kollision des Fahrzeugs (100) aktivieren zu können.

## Claims

1. Method for identifying a polarity of a freewheeling diode (106) interconnected in parallel with an inductive actuator (104) for a safety device (102) for a vehicle (100), wherein the method comprises the following steps:
applying (231) a test current (341) to a connection (114) of the freewheeling diode (106); and
performing (233) a comparison between a voltage (343) applied to the connection (114) and a threshold voltage (345), during the application (231) of the test current (341), wherein a result (124) of the comparison indicates the polarity of the freewheeling diode (106),
**characterized by**
a step of receiving a diagnosis signal via an interface to a data bus (126), wherein the step of applying (231) the test current (341) is executed in response to the reception of the diagnosis signal.

2. Method according to Claim 1, in which, in the application step (231), the test current (341) is applied with a current intensity that is lower than a current intensity of an activation current for triggering the inductive actuator (104).

3. Method according to one of the preceding claims, in which the step of applying (231) the test current (341) is performed during an initialization phase or during a normal operating mode of a control device (112) for controlling the inductive actuator (104).

4. Method according to one of the preceding claims, in which, in the application step (231), the test current (341) is applied to the connection (114) that corresponds to the cathode of the freewheeling diode (106) for the case in which the freewheeling diode (106) is interconnected with the correct polarity in relation to the actuator (104).

5. Method according to one of the preceding claims, in which, in the performance step (233), the result (124) of the comparison indicates that the freewheeling diode (106) is interconnected with the correct polarity when the voltage (343) applied to the connection (114) is greater than the threshold voltage (345) and/or in which, in the performance step (233), the result (124) of the comparison indicates that the freewheeling diode (106) is interconnected with reverse polarity when the voltage (343) applied to the connection (114) is lower than the threshold voltage (345).

6. Method according to one of the preceding claims, in which, in the performance step (233), at least one further comparison between the voltage (343) applied to the connection (114) and the threshold voltage (345), during the application (231) of the test current (341), is performed, and a combination of the results (124) from the comparisons indicates the polarity of the freewheeling diode (106).

7. Apparatus (110) for checking a polarity of a freewheeling diode (106) interconnected in parallel with an inductive actuator (104) for a safety device (102) for a vehicle (100), wherein the apparatus (110) has the following features:
a device (120) for applying a test current (341) to a connection (114) of the freewheeling diode (106); and
a device (122) for performing a comparison between a voltage (343) applied to the connection (114) and a threshold voltage (345), during the application (231) of the test current (341), wherein a result (124) of the comparison indicates the polarity of the freewheeling diode (106), wherein the apparatus (110) is configured to receive a diagnosis signal via an interface to a data bus (126), wherein the application (231) of the test current (341) is executed in response to the reception of the diagnosis signal.

8. Actuator circuit having the following features:
an inductive actuator (104) for activating a safety device (102);
a freewheeling diode (106) having a first connection (114) and a second connection (116), wherein the freewheeling diode (106) is interconnected in parallel with the inductive actuator (104) by means of the first and the second connection (114, 116); and
an apparatus (110) according to Claim 7 for checking a polarity of the freewheeling diode (106), wherein the device (120) for applying the test current (341) is designed to apply the test current (341) to the first connection (114) of the freewheeling diode (106) and the device (122) for performing the comparison is designed to perform the comparison between the voltage (343) applied to the first connection (114) and the threshold voltage (345).

9. Safety apparatus for a vehicle (100), wherein the safety apparatus has the following features:
a safety device (102) for protecting a person in the event of a collision of the vehicle (100); and
an actuator circuit according to Claim 8, wherein the inductive actuator (104) of the actuator circuit is coupled to the safety device (102); and
a control device (112) for providing an activation current to the inductive actuator (104) in order to be able to activate the inductive actuator (104) and hence the safety device (102) coupled to the inductive actuator (104) in the event of a collision of the vehicle (100).

## Revendications

1. Procédé permettant d'identifier une polarité d'une diode de roue libre (106) connectée en parallèle à un actionneur inductif (104) pour un équipement de sécurité (102) destiné à un véhicule (100), le procédé comprenant les étapes suivantes consistant à :
appliquer (231) un courant d'essai (341) à une borne (114) de la diode de roue libre (106) ; et
exécuter (233) une comparaison entre une tension (343) appliquée à la borne (114) et une tension de seuil (345) pendant l'application (231) du courant d'essai (341), un résultat (124) de la comparaison indiquant la polarité de la diode de roue libre (106),
**caractérisé par** une étape de réception d'un signal de diagnostic par l'intermédiaire d'une interface avec un bus de données (126), l'étape d'application (231) du courant d'essai (341) étant exécutée en réponse à la réception du signal de diagnostic.

2. Procédé selon la revendication 1, dans lequel, à l'étape d'application (231), le courant d'essai (341) est appliqué avec une intensité de courant qui est inférieure à une intensité de courant d'un courant d'activation pour déclencher l'actionneur inductif (104) .

3. Procédé selon l'une quelconque des revendications précédentes, dans lequel l'étape d'application (231) du courant d'essai (341) est exécutée pendant une phase d'initialisation ou pendant un mode de fonctionnement normal d'un équipement de commande (112) pour commander l'actionneur inductif (104).

4. Procédé selon l'une quelconque des revendications précédentes, dans lequel, à l'étape d'application (231), le courant d'essai (341) est appliqué à la borne (114) qui correspond à la cathode de la diode de roue libre (106) au cas où la diode de roue libre (106) est connectée avec la polarité correcte par rapport à l'actionneur (104).

5. Procédé selon l'une quelconque des revendications précédentes, dans lequel, à l'étape d'exécution (233), le résultat (124) de la comparaison indique que la diode de roue libre (106) est connectée avec la polarité correcte si la tension (343) appliquée à la borne (114) est supérieure à une tension de seuil (345), et/ou dans lequel, à l'étape d'exécution (233), le résultat (124) de la comparaison indique que la diode de roue libre (106) est connectée avec une polarité inversée si la tension (343) appliquée à la borne (114) est inférieure à la tension de seuil (345).

6. Procédé selon l'une quelconque des revendications précédentes, dans lequel, à l'étape d'exécution (233), au moins une autre comparaison entre la tension (343) appliquée à la borne (114) et la tension de seuil est exécutée pendant l'application (231) du courant d'essai (341) et indique une combinaison des résultats (124) des comparaisons de la polarité de la diode de roue libre (106).

7. Dispositif (110) permettant de vérifier une polarité d'une diode de roue libre (106) connectée en parallèle à un actionneur inductif (104) pour un équipement de sécurité (102) destiné à un véhicule (100), le dispositif (110) présentant les particularités suivantes :
un équipement (120) pour appliquer un courant d'essai (341) à une borne (114) de la diode de roue libre (106) ; et
un équipement (122) pour exécuter une comparaison entre une tension (343) appliquée à la borne (114) et une tension de seuil (345) pendant l'application (231) du courant d'essai (341), un résultat (124) de la comparaison indiquant la polarité de la diode de roue libre (106), le dispositif (110) étant configuré pour recevoir un signal de diagnostic par l'intermédiaire d'une interface avec un bus de données (126), l'application (231) du courant d'essai (341) étant exécutée en réponse à la réception du signal de diagnostic.

8. Circuit d'actionneur ayant les particularités suivantes :
un actionneur inductif (104) pour activer un équipement de sécurité (102) ;
une diode de roue libre (106) équipée d'une première borne (114) et d'une deuxième borne (116), la diode de roue libre (106) étant connectée par l'intermédiaire de la première et de la deuxième borne (114, 116) en parallèle avec l'actionneur inductif (104) ; et
un dispositif (110) selon la revendication 7 pour vérifier une polarité de la diode de roue libre (106), l'équipement (120) d'application du courant d'essai (341) étant réalisé pour appliquer le courant d'essai (341) à la première borne (114) de la diode de roue libre (106), et l'équipement (122) d'exécution de la comparaison étant réalisé pour exécuter la comparaison entre la tension (343) appliquée à la première borne (114) et la tension de seuil (345).

9. Dispositif de sécurité pour un véhicule (100), dans lequel le dispositif de sécurité présente les particularités suivantes :
un équipement de sécurité (102) pour protéger une personne en cas de collision du véhicule (100) ; et
un circuit d'actionneur selon la revendication 8, dans lequel l'actionneur inductif (104) du circuit d'actionneur est couplé à l'équipement de sécurité (102) ; et
un équipement de commande (112) pour fournir un courant d'activation à l'actionneur inductif (104) afin de pouvoir activer l'actionneur inductif (104) et ainsi l'équipement de sécurité (102) couplé à l'actionneur inductif (104) en cas de collision du véhicule (100).
